# EUROPEAN PATENT APPLICATION

(11) **EP 4 431 633 A1**
(43) Date of publication of application: **18.09.2024**
(21) Application number: 23217887.1
(22) Date of filing: 19.12.2023
(51) Int. Cl.: C23C 16/04, C23C 16/44, C23C 16/458, C23C 16/54, B05C 13/02, B05C 15/00, D06M 23/00

(54) **CONTINUOUS VACUUM PROCESSING OF FIBER TOWS**

(30) Priority: 12.01.2023 US 202318153859
(71) Applicant: Honeywell International Inc., Charlotte, NC 28202 (US)
(72) Inventor: MEHR, Mehrad, Charlotte, 28202 (US); JADIDIAN, Bahram, Charlotte, 28202 (US)
(74) Representative: Haseltine Lake Kempner LLP

(57) **Abstract**

The disclosure describes continuous vacuum processing of a fiber tow. Continuous vacuum processing includes passing a fiber tow through a plurality of vacuum chambers and operating at least two vacuum chambers of the plurality of vacuum chambers at a different level of vacuum pressure than each other.

## Description

### TECHNICAL FIELD

The disclosure relates to vacuum processing of fibers.

### BACKGROUND

Fibers may be bundled into a fiber tow that includes tens or hundreds of individual fibers. The resulting fiber tow may be used in industry in all sorts of applications. For example, ceramic fiber tows are desired for their high strength, low weight, and/or temperature resistance relative to other materials. Fiber tows may be treated in one or more ways to provide improved properties. For example, fiber tows may undergo one or more of a chemical vapor deposition (CVD) process, chemical vapor infiltration (CVI) process, a coating process, an inspection process, or the like. One or more of these processes may be conducted under vacuum.

### SUMMARY

In some examples, the disclosure is directed to a technique for continuous vacuum processing of a fiber tow. The technique includes passing a fiber tow through a plurality of vacuum chambers. At least two of the plurality of vacuum chambers are operated at a different level of vacuum pressure than each other.

In some examples, the disclosure is directed to a system which includes a plurality of vacuum chambers and a fiber system. The fiber system is configured to continuously pass a fiber tow through the plurality of vacuum chambers. At least two vacuum chambers of the plurality of vacuum chambers are configured to operate at a different level of vacuum pressure from each other.

The details of one or more examples of the disclosure are set forth in the accompanying drawings and the description below. Other features, objects, and advantages of the disclosure will be apparent from the description and drawings, and from the claims.

### BRIEF DESCRIPTION OF DRAWINGS

FIG. 1 is a schematic diagram illustrating an example system for continuous vacuum processing of a fiber tow according to some examples of the present disclosure.
FIG. 2 is a schematic cross-sectional diagram illustrating a portion of the fiber tow of FIG. 1 covered in a layer of sealant material according to some examples of the present disclosure.
FIG. 3 is a schematic cross-sectional diagram illustrating a portion of the example fiber tow of FIG. 1.
FIG. 4 is a schematic cross-sectional diagram illustrating a portion of the example fiber tow of FIG. 1.
FIG. 5 is a flowchart illustrating an example technique for vacuum processing a fiber tow according to some examples of the present disclosure.

### DETAILED DESCRIPTION

Vacuum processing of a fiber tow to coat, convert (e.g., react), or inspect the fiber tow may be done by a batch process. In a batch process, a discrete number and length of fiber tows are treated under vacuum. Vacuum processes of fibers included, but are not limited to, chemical vapor infiltration (CVI), chemical vapor deposition (CVD), slurry deposition processes, coating processes, etching processes (e.g., reactive ion etching), inspection, characterization, or quality control processes, or the like. Time and labor may be required to set up and changeover between batches of fiber tows. For examples, cleaning of equipment may be necessary between batches, or time and energy may be used to heat up and/or cool down the vacuum processing system.

In one or more examples of the present disclosure, systems and techniques for continuous vacuum processing of fiber tows are described. The described systems and techniques may be used in any suitable system where a fiber tow is to be treated under vacuum. For example, boron nitride coating, vacuum annealing of fibers, pyrolytic carbon coating, CVI, CVD, other densification process, or the like. Furthermore, characterization or inspection techniques which require a vacuum may also be conducted (e.g., scanning electron microscopy). In one example use, which is not intended to be limiting, carbon fiber tows may be converted (e.g., chemically reacted) to form metal carbide coated carbon fibers or metal carbide fibers.

Vacuum processing systems and techniques according to the present disclosure may address one or more of the problems with batch vacuum processing. For example, coating or converting fibers tows continuously may have one or more advantages over batch processing. For example, time and labor may be saved be eliminating time and/or energy wasted between batches. Additionally, or alternatively, variation between batches may be reduced because the system may be maintained at desirable continuous operating conditions, rather than shut down between batches. Additionally, performing characterization or inspection techniques with systems and techniques according to the present disclosure may improve uniformity (e.g., of a coating) and quality control.

In some examples, continuous vacuum processing of fiber tows according to the present disclosure may include passing a fiber tow through a plurality of vacuum chambers that are arranged in series. In some examples, each vacuum chamber of the plurality of vacuum chambers may be outfitted with a corresponding vacuum pump of a plurality of vacuum pumps. The plurality of vacuum chambers may be configured to step down (e.g., reduce) the pressure at each successive vacuum chamber, until a portion of the fiber tow passes into a central vacuum chamber.

The central vacuum chamber may, in some examples, consist of or include an objective chamber configured to characterize, coat or convert the portion of the fiber tow inside the central vacuum chamber. The operating pressure in the central vacuum chamber may be the lowest pressure (i.e., highest vacuum level) of the plurality of vacuum chambers. Although described herein as a central vacuum chamber, the central vacuum chamber need not be precisely the middle vacuum chamber of the plurality of chambers. Upon reaching the central vacuum chamber, the fiber tow may be characterized, coated, converted (e.g., partially converted or completely converted), or otherwise vacuum processed. The central vacuum chamber may be any processing unit that requires such pressure levels for operation. In some instances, the central vacuum chamber may be a vacuum furnace, a depositions system, coating system, reactive ion etching system, freeze drying system, and/or an imaging or characterization system that requires vacuum (e.g., a scanning electron microscope). In this way, continuous vacuum processing and continuous quality control may be implemented on a fiber line.

Next, the fiber tow may pass through a second set of vacuum chambers configured to step up (e.g., increase) the pressure at each successive vacuum chamber until the fiber tow exits the vacuum system. In this way, a fiber tow may be continuously processed under vacuum because the pressure in the central vacuum chamber may be maintained below an acceptable threshold level for vacuum processing by the plurality of vacuum chambers on either side of the central vacuum chamber. Advantageously, the plurality of vacuum chambers may substantially prevent or minimize entry of an atmosphere external to the vacuum system from reaching the central vacuum chamber. Thus, even though continuous vacuum processing of a fiber tow may involve passing the fiber tow through an inlet to the vacuum system and an outlet of the vacuum system, the plurality of vacuum chambers, arranged both before and after the central vacuum chamber, may provide for an acceptable vacuum level for vacuum processing in the central vacuum chamber.

Although described primarily herein as a single fiber tow, other numbers of fiber tows are considered suitable for use in systems and techniques described herein. For example, two, three, four, or more discrete fiber tows may be vacuum processed simultaneously. Furthermore, although described below primarily using the example of a carbon fiber being vacuum processed to convert to a metal carbide fiber, other materials are considered for the disclosed vacuum processing systems and techniques. For example, fiber tows comprising boron may be converted to boron nitride fibers in the central vacuum chamber. Other fibers suitable for vacuum processing treatment by CVI, CVD, coating processes, annealing processes, inspection or quality control process, or the like may also be performed in the disclosed systems.

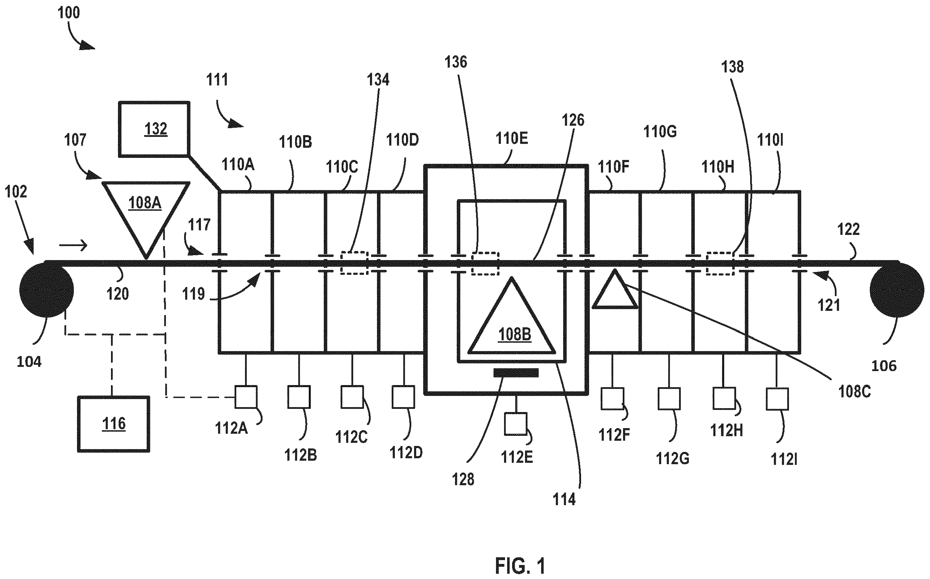

FIG. 1 is a schematic diagram illustrating an example system 100 for continuous vacuum processing of a fiber tow 120. System 100 includes fiber system 102, sealing system 107, vacuum system 111, and controller 116.

Fiber system 102 is configured to pass fiber tow 120 through vacuum system 111. Although illustrated as a single fiber tow 120, fiber system 102 may be configured to pass multiple fiber tows, and may include multiples of any of the elements of fiber system 102. Fiber system 102 includes starter core 104 and winding core 106. Starter core 104 and/or winding core 106 may be coupled to a tensioner (not shown), for example, an electric motor and/or a braking system configured to provide a selected tension on fiber tow 120 as core 104 is rotated to pass fiber tow 120 through vacuum system 111. Fiber system 102 may additionally or alternatively include one or more tensioning rollers (e.g., nip rollers, idlers, adjustable and/or translatable idlers, web steering rollers and the like) configured to provide a selected tension on fiber tow 120 (or a web material or removable backing material onto which fiber tow 120 is disposed) as starter core 104 is rotated to pass fiber tow 120 through vacuum system 111 (along the direction of the arrow in FIG. 1). In some examples, the selected tension may affect a density of fiber tow 120, e.g., a fiber volume and/or density relative to a total volume and/or density of fiber tow 120.

Fiber system 102 may be selectively controlled to control the feed rate of fiber tow 120 through vacuum system 111, such that the dwell time of fiber tow 120 within vacuum system 111 (e.g., objective chamber 114 of vacuum system 111) may be controlled. Varying the speed with which fiber 120 is fed may also be used to control a thickness of a coating of sealing material applied by sealing system 107, or an infiltration distance of material applied by sealing system 107 by controlling a length of dwell time in one or more vacuum chambers of vacuum system 111.

System 100 includes vacuum system 111. Vacuum system 111 is configured to continuously vacuum process fiber tow 120. Vacuum system 111 includes plurality of vacuum chambers 110A, 110B, 110C, 110D, 110E, 110F, 110G, 110H, and 110I (collectively "vacuum chambers 110"). Vacuum system 111 also includes one or more vacuum pumps configured to evacuate vacuum chambers 110. In some examples, vacuum system 111 may include a plurality of vacuum pumps 112A, 112B, 112C, 112D, 112E, 112F, 112G, 112H, and 112I (collectively "vacuum pumps 112") As such, vacuum system 111 may include a corresponding vacuum pump 112A for each vacuum chamber 110A of the plurality of vacuum chambers 110. Although illustrated as defining a substantially rectangular cross-sectional area, vacuum chamber may take on any other suitable shape. For example, vacuum chambers 110 may be sections of tube surrounding fiber tow 120. Advantageously, tube-shaped vacuum chambers 110 may substantially reduce the volume that must be evacuated by vacuum pumps 112.

Vacuum chambers 110 may be arranged in series, such that fiber tow 120 is configured to pass through first inlet 117 into first vacuum chamber 110A, through first vacuum chamber outlet 119 and into second vacuum chamber 110B, and so on until fiber tow 120 passes out of last vacuum chamber 110I through outlet 121. Several vacuum chamber inlets and outlets are not specifically called out by reference numerals in FIG. 1 for clarity. Inlet 117 and outlet 119 may be defined in a wall of vacuum chamber 110A, as shown. In some examples, as illustrated, first vacuum chamber 110A and second vacuum chamber 110B may share a wall, such that first vacuum chamber outlet 119 also defines an inlet to second vacuum chamber 119B. However, in some examples each vacuum chamber 110A-110I may be a separate, discrete chamber with its own inlet and outlet connected with a tube.

The aperture in the wall of 110A may be defined to reduce leakage of the atmosphere exterior to vacuum system 111 into vacuum system 111. For example, a diameter of inlet 117 and/or outlet 119 may be similar to a diameter of fiber tow 120, such that there is a tight tolerance (e.g., contact between) fiber tow 120 and inlet 117, outlet 119, or both, so that leakage is reduced. Additionally, or alternatively, inlet 117 and/or outlet 119 may extend along a length of fiber tow 120, and may in some examples define a tortuous path along the length of fiber tow 120, which may further reduce leakage. Additionally, or alternatively, as will be described below, system 100 may include sealing system 107, which may be configured to reduce leakage of atmosphere into vacuum system 111 by applying a layer of sealing material to fiber tow 120, as will be further described below.

Although the illustrated example of FIG. 1 includes nine different vacuum chambers 110, any suitable number of vacuum chambers may be included in the plurality of vacuum chambers, for example three vacuum chambers, or at least five vacuum chambers. In some examples, vacuum system 111 may include up to 20 vacuum chambers 110. Furthermore, although central vacuum chamber 110E is illustrated as being in the middle of the series of vacuum chambers 110 such that fiber tow 120 is configured to pass through four chambers before entering central vacuum chamber 110E and four chambers after exiting central vacuum chamber 110E, central vacuum chamber 110E need not be located exactly in the middle of vacuum system 111. For example, more vacuum chambers 110 may be disposed before central vacuum chamber 110E, or more vacuum chambers 110 may be disposed after central vacuum chamber 110E.

At least two vacuum chambers 110A, 110B of vacuum chambers 110 may be configured to operate at a different level of vacuum pressure from each other during vacuum processing of fiber tow 110. For example, first set of vacuum chambers 110A-110D may be configured to step down (e.g., reduce) a pressure from an atmospheric pressure (e.g., standard atmospheric pressure, about 760 torr) outside of vacuum system to an operating pressure for a vacuum processing operation inside central vacuum chamber 110E. For example, central vacuum chamber 110E may be configured to operate at less than, for example, about 500 millitorr, or about 250 millitorr.

To achieve this level of vacuum in central vacuum chamber 110E, first vacuum chamber 110A may be configured to operate at about 50 torr, second vacuum chamber 110B may be configured to operate at about 25 torr, third vacuum chamber 110C may be configured to operate at about 10 torr, and fourth vacuum chamber 110D may be configured to operate at about 1 torr. It should be understood that these numbers are merely exemplary and not intended to be limiting. It should also be understood that as used herein, the term "about" to describe a value includes values within plus or minus 10% of the stated value.

Since the pressure may be reduced over the first set of vacuum chambers 110A-110D, some minimal level of leakage resulting from the passage of fiber tow 120 from the exterior atmosphere into first vacuum chamber 110A may be acceptable, because the successive chambers 110B-110D may be configured to further reduce pressure. In some examples, vacuum pumps 112 may be similar to each other. Advantageously, vacuum pumps 112 may be standard vacuum pumps, which may be relatively widely available and inexpensive, because the work required to reach the threshold vacuum level for the vacuum process in central vacuum chamber 110E may be shared across multiple vacuum pumps 112A-112E.

Vacuum system 111 includes second set of vacuum chambers 110F-110I. Vacuum chambers 110F-110I may be configured to step up (e.g., increase) a pressure from the operating pressure for a vacuum processing operation inside central vacuum chamber 110E (e.g., about 500 millitorr) to the atmospheric pressure (e.g., about 760 torr) outside of vacuum system 111, in a manner similar to and opposite the operation of first set of vacuum chambers 110A-110D. For example, vacuum chamber 110F may be configured to operate at about 1 torr, vacuum chamber 110G may be configured to operate at about 10 torr, vacuum chamber 110H may be configured to operate at about 25 torr, and vacuum chamber 110I may be configured to operate at about 50 torr. Absent second set of vacuum chambers 110F-110I, the external atmosphere beyond vacuum system 111 may leak directly into central vacuum chamber 110E, which would prevent central chamber 110E from reaching the threshold vacuum level for vacuum processing.

In some examples, central vacuum chamber 110E may include an objective chamber 114. Objective chamber 114 may, in some examples, be a retort configured to be placed in a vacuum furnace, and central vacuum chamber 110E may be a vacuum furnace configured to house objective chamber 114. Alternatively, vacuum chamber 110E may be configured to serve the dual purpose of acting as an objective chamber. In other words, objective chamber 114 need not be a separate component of vacuum system 111. In some examples, as mentioned above central vacuum chamber 110E may be configured as a coating chamber, a CVI and/or CVD chamber, slurry burnout chamber, an etching chamber, an imaging chamber, or another chamber suitable for a process conducted under vacuum.

In some examples, objective chamber 114 may be configured to chemically react portion 126 of fiber tow 120 disposed within objective chamber 114. As such, fiber tow 120 be converted within objective chamber 114, and may exit objective chamber 114 with at least part of fiber tow 120 having a different chemical composition. Thus fiber tow 120 may become reacted fiber tow 122, indicated by the color change and reference number change in FIG. 1. Since fiber system 102 may be configured to replace portion 126 with a new portion of fiber tow 120, objective chamber 114 may be configured to continuously react fiber tow 120 to form reacted fiber tow 122.

In some examples, one or more of the plurality of vacuum chambers 110 may be configured to heat fiber tow 120 during a continuous vacuum process. For example, central vacuum chamber 114 may include one or more heating elements 128. Heating element(s) 128 may be include any suitable means for heating, such as an electrical element, a gas heating element, or the like. Heating element(s) 128 may be configured to heat central vacuum chamber 110E to a temperature suitable for the continuous vacuum process, such as a temperature for coating, chemical vapor infiltration/ chemical vapor deposition, etc. As such, objective chamber 114 may be heated to a temperature of at least about 1400 degrees Celsius.

System 100 also includes sealing system 107. Sealing system 107 may be configured to apply a sealing material (not illustrated) to fiber tow 120. The sealing material may be configured to reduce leakage of external atmosphere into one or more vacuum chambers 110, such as central vacuum chamber. Sealing system may include one or more deposition members 108A, 108B, 108C (collectively "deposition members 108") configured to apply a layer of sealing material fiber tow 120. For example, a layer of sealing material may be applied be deposition member 108A before fiber tow 120 enters first vacuum chamber 110A. The sealing material may assist in forming a seal between fiber tow 120 and the wall of vacuum chamber 110A as fiber tow 120 passes through inlet 117. The sealing material may include any material or mixture of materials that assists in reducing leakage of the external environment into vacuum chamber 110A. For example, water, lubricants such as vacuum grease, or other sealants may be applied to fiber tow 120 by deposition member 108A. Deposition members 108 may apply the sealant via a spray, such as by one or more spray nozzles. Additionally, or alternatively, deposition members may include a brush system or a bath system configured to apply a layer of sealant material.

In some examples, the applied layer sealing material may evaporate in the reduced pressure environment inside vacuum chamber 110A. Accordingly, sealing system may include additional deposition member 108B, 108C configured to apply or additional layers of sealing material. For example, each of vacuum chambers 110 may include a corresponding deposition member 108 configured to apply a layer of sealing material configured to reduce leakage into the next vacuum chamber in the sequence.

In some examples, system 100 may include a coating application system. In the illustrated example of FIG. 1, sealing system 107 is configured to act as the coating application system, but a separate coating application system may be included in some examples. In the illustrated example of FIG. 1, deposition member 108A and/or deposition member 108B may be configured to apply a coating material to fiber tow 120. The coating material may be configured to act as a sealing layer surrounding from deposition member 108A to objective chamber 114, which may be at a low enough pressure and high enough pressure to prompt the carrier materials for the coating material to evaporate, or for the coating material to be vaporize for vapor deposition and/or infiltration of portion 126 of fiber tow 120 disposed within objective chamber 114. Deposition member 108C may then apply a sealing material such as vacuum grease or sealing through second set of vacuum chambers 110F-110I. In some examples, the coating material may be a metal slurry configured to react (e.g., chemically react) with fiber tow 120 to generate reacted fiber tow 122.

In some examples, the metal application system may include deposition member 108B, which may be disposed within objective chamber 114. In some examples, deposition member 108B may be configured to apply metal to fiber tow 120 from a vapor. For instance, deposition member 108B may be a silicon boat or silicon ingot which is configured to vaporize in the environment of objective chamber 114 and vapor deposit on fiber tow 120. In other examples, deposition member may be configured to coat fiber 120 with a coating material that includes a nitride or oxide.

In some examples, at least one vacuum chamber 110A system 100 may include an inert gas inlet (not called out with a reference numeral for clarity) configured to receive inert gas (e.g., argon) from an inert gas supply 132. Outfitting first vacuum chamber 110A with an inert gas, in some examples, may advantageously assist in vacuum processing fiber tow 120, because leakage into successive vacuum chambers 110 may be of the inert gas that does not interfere with the vacuum process as much as gases from the external atmosphere.

In some examples, system 100 may also include controller 116. Controller 116 may include, for example, a computing device, a desktop computer, a laptop computer, a workstation, a server, a mainframe, a cloud computing system, a tablet, a smart phone, or the like. Controller 116 may be configured to control operation of system 100, including, for example, the power supplied to fiber system 102, vacuum system 111, and/or sealing system 107. As such, the speed of fiber tow 120 and thus the dwell time of fiber tow 120 in vacuum system 111 may be selectively configured for desired vacuum processing. Controller 110 may be communicatively coupled to the various component of system 100 including, e.g., starter core 104, vacuum pump 112A, deposition member 108A, and/or the like using respective communication connections. Only a portion of these connections are illustrated in FIG. 1 for clarity. In some examples, the communication connections may include network links, such as Ethernet, ATM, or other network connections. Such connections may be wireless and/or wired connections. In other examples, the communication connections may include other types of device connections, such as USB, IEEE 1394, or the like. In some examples, controller 116 may include control circuitry, such as one or more processors, including one or more microprocessors, digital signal processors (DSPs), application specific integrated circuits (ASICs), field programmable gate arrays (FPGAs), or any other equivalent integrated or discrete logic circuitry, as well as any combinations of such components. The term "processor" or "processing circuitry" may generally refer to any of the foregoing logic circuitry, alone or in combination with other logic circuitry, or any other equivalent circuitry.

Fiber tow 120 may be any suitable fiber tow suitable for vacuum processing. In some examples, fiber tow 120, may be a bundle of individual fibers linearly aligned. As such, fiber 120 may include a plurality of continuous filaments. Each tow may include about 10 to about 10,000 individual fibers unidirectionally aligned to form a single tow. The individual fibers in the tow may define an individual fiber diameter. In some examples, the individual fiber diameter may be in a range of from about 0.1 micrometers to about 100 micrometers. In some examples, fiber tow 120 may include carbon, boron, aluminum, silica, other ceramic materials, mixtures thereof, or other fibers intended to be treated by continuous vacuum processing.

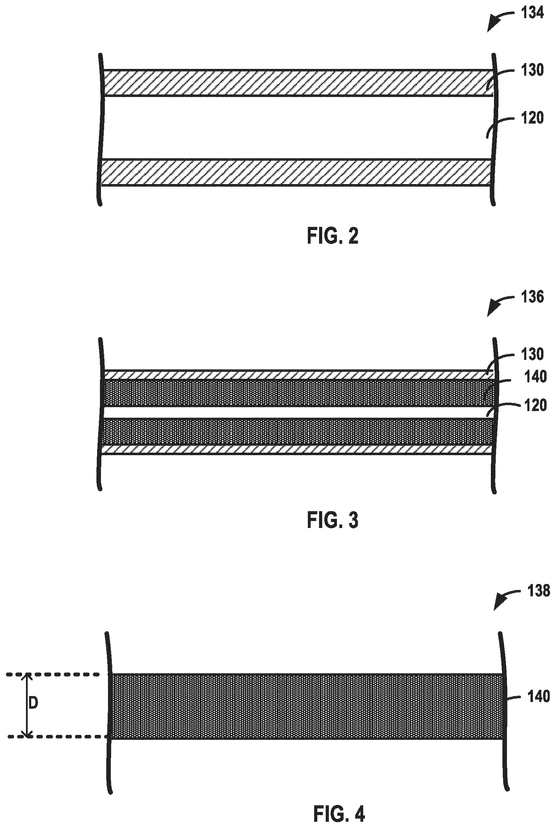

In some examples, as mentioned above, fiber tow 120 may be a carbon fiber tow, and one or more deposition elements 108A, 108B of sealant system 107 may be configured to apply a coating material which includes a metal slurry. In such examples, system 100 may be configured to generate a fiber tow comprising a metal carbide, because the metal slurry may infiltrate and react with carbon of carbon fiber tow 120. FIGS. 2-4 illustrate portions of fiber tow 120 at various points throughout the process of conversion of fiber tow 120 from a carbon fiber tow to a fiber tow comprising metal carbide. FIGS. 2-4 illustrate portions of fiber tow 120 within windows 134, 136, and 138 of FIG. 1 during an example vacuum process, respectively. Although FIGS. 2-4 discuss an example vacuum process in which a carbon fiber is converted to a metal carbide fiber, it should be repeated that a chemical reaction within central vacuum chamber 110E is not required. Rather, a coating process, an inspection process, or another vacuum process may be performed within system 100.

FIG. 2 is a schematic cross-sectional diagram illustrating portion 126 of fiber tow 120 within window 134 of FIG. 1. Fiber tow 120 is covered in layer 130 of sealant material, which in this example is a coating material that includes a metal slurry, such as silicon slurry. In the illustrated example, FIG. 2 is a cross section of a portion of fiber tow 120 of FIG. 1 after deposition member 108A has applied a layer of coating material 130. The slurry may include a metal (e.g., silicon) and one or more carriers configured to maintain the proximity of the metal and the surface of fiber tow 120. It should be understood that system 100 may be used to generate fiber tows comprising or consisting of metal carbide even where only deposition member 108B is configured to apply a layer of metal to fiber tow 120 in vapor form.

Prior to reaction with a metal, fiber tow 120 may include a surface portion (e.g., outer-most 10-25 microns) that includes carbon filaments capable of reacting with the metal to form a metal carbide. Without being limited to any particular theory, the carbon filaments of the surface portion may have a particular composition and/or morphology, such as microstructure, phase composition, geometry of component phases, morphology of components phases, and/or dimensions and distribution of ceramic fibers or pores, crystal structure, presence and type of impurities, particle morphology shape and size, crystal surface terminations (e.g., active facets), crystal defects, and/or surface functionalization. This particular composition and/or morphology may result in a reaction with the metal according to particular reaction thermodynamics and kinetics, such as a temperature of reaction and a rate of reaction.

Turning to FIG. 3, the portion of fiber tow 120 within window 136, which is located within objective chamber 114, is illustrated. In objective chamber 114, the metal the metal of the metal slurry of layer 130 may react with carbon of carbon of carbon fiber tow 120 to form metal carbide 140. The environment inside objective chamber 114 may be at a low enough pressure and high enough temperature such that the metal may melt and/or vaporize. Objective chamber 114 may maintain a vapor pressure of the metal at the surface of carbon fiber tow 120 in stoichiometric excess. A variety of parameters, such as a temperature at surface 62, a concentration (e.g., as indicated by pressure) of the metal near fiber tow 120, and a dwell time within objective chamber 114, may be controlled to maintain the metal at stoichiometric excess and encourage migration of the metal into, and reaction with, carbon of carbon fiber tow 120. In the illustrated example, the metal is silicon. As such, the temperature of objective chamber 114 may be maintained at greater than about 1400°C, the pressure may be maintained at less than about 500 millitorr, and the dwell time of any individual portion of fiber tow 120 within objective chamber 114 may be between on the order of seconds to minutes.

In some instances, this reaction may be limited by diffusion of the metal into fiber tow 120. As the metal reacts with the individual fibers of carbon fiber tow 120, the newly formed metal carbide may form a diffusion barrier separating the reactants (e.g., carbon and metal), which may stop the thickening and further creation to form thicker metal carbides (e.g., by preventing metal from further penetrating into a depth of the surface portion of fiber tow 120 and/or preventing diffusion of carbon out of fiber tow 120 to react with the metal).

FIG. 4 is a schematic cross-sectional diagram illustrating the example portion of fiber tow 120 within window 138 of FIG. 1. In this example, after the fiber tow has exited objective chamber 114 of central vacuum chamber 110E, fiber tow 120 has been converted to reacted fiber tow 122. In the illustrated example of FIG. 4, a diameter of the fiber tow may correspond to a size for which the metal may infiltrate and react (e.g., less than a diffusion limit), such as less than about 50 micrometers (µm), or between about 10 µm and about 50 µm. Where the diameter of the fiber tow is less than the diffusion limit, carbon fiber tow 120 may be completely converted to reacted fiber tow 122, which may consist of or consist essentially of metal carbide 140. In some examples, any remaining metal or carrier on fiber tow 120 may be removed, such as through evaporation. The resulting reacted fiber tow 122 may be a relatively homogeneous metal carbide having a relatively uniform thickness.

As such, system 100 may be configured to generate a reacted fiber tow 122. comprising a metal carbide. Reacted fiber tow 122 may be stable at temperatures of up to about 3600°F (about 2000°C). In this context, "stable" may mean that reacted fiber tow 122 does not degrade into its constituent elements, does not react with carbon, and/or does not react with other elements or compounds present in the environment in reacted fiber tow 122 is eventually used, for example in aerospace applications. Although the example discussed herein includes converting a carbon fiber tow into a metal carbide fiber tow, any continuous fiber may be vacuum processed or inspected using system 100.

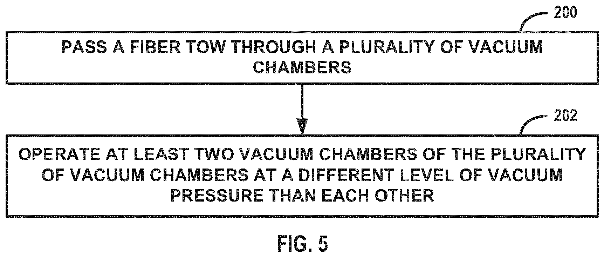

FIG. 5 is a flowchart illustrating an example technique for vacuum processing a fiber tow according to some examples of the present disclosure. Although the technique of FIG. 5 is discussed primarily with respect to system 100 of FIG. 1, system 100 of may be used to perform other techniques, and the illustrated technique may be performed using other systems.

The technique of FIG. 5 includes passing fiber tow 120 through plurality of vacuum chambers 110. (200). In some examples, vacuum chambers 110 may be arranged in series.

The technique of FIG. 5 also includes operating at least two vacuum chamber 110A, 110B at a different level of vacuum pressure than each other (202). In some examples, passing fiber tow 120 through vacuum chambers 110 may include passing fiber tow 120 through central vacuum chamber 110E, which may be operated at the lowest pressure of vacuum chambers 110. For example, central vacuum chamber 110E may be operated such that the pressure inside central vacuum chamber 110E is less than about 500 millitorr. In some examples, central vacuum chamber 110E may include a chemical vapor deposition (CVD) chamber, a chemical vapor infiltration (CVI) chamber, a coating chamber, an inspection chamber, or the like.

In some examples, central vacuum chamber 110E may include objective chamber 114, which may be separate from or the same as central vacuum chamber 110E. The technique of FIG. 5 may further include chemically reacting portion 126 of fiber tow 120 in objective chamber 114. Additionally, or alternatively, the technique of FIG. 5 may include coating, or merely inspecting, portion 126 of fiber tow 120 with a coating material in objective chamber 114. In some examples, chemically reacting fiber tow 120 may include converting at least part of portion 126 of fiber tow 120 from carbon to a metal carbide. The resulting metal carbide may include silicon carbide, titanium carbide, tungsten carbide, or combinations thereof. In some examples, chemically reacting fiber tow 120 to form reacted fiber tow 122 may include completely converting the fiber tow from carbon to metal carbide.

Vacuum chambers 110 may be arrange in series such that vacuum chamber 110 include first vacuum chamber 110A, which fiber tow 120 passes through first, and last vacuum chamber 110I, which fiber tow 120 passes through last. The technique of FIG. 5 may include operating first vacuum chamber 110A and last vacuum chamber 110I at a higher pressure (lower vacuum level) than central vacuum chamber 110E.

In some examples, the technique of FIG. 5 may also include heating objective chamber 114. In some examples, heating objective chamber 114 may include raising the temperature inside objective chamber 114 to at least about 1400 degrees Celsius.

In some examples, the technique of FIG. 5 may include passing fiber tow 120 through inlet 117, which may be defined by vacuum chamber 110A. Fiber tow 120 may also be passed through outlet 119 of vacuum chamber 110A. In some examples, at least two vacuum chamber 110A, 110B may share a wall. In some examples, any or all of vacuum chamber 110 may be a tube surrounding fiber tow 120.

In some examples, the technique of FIG. 5 may include applying a layer of sealing material 130 to fiber tow 120. Applying layer 130 to the fiber tow 120 may reduce leakage out of vacuum chamber 110A. In some examples, the technique may include applying sealing material layer 130 with deposition element 108A, which may be positioned before fiber tow 120 first vacuum chamber 110A. In some examples, sealing material layer 130 may include a coating material configured to be deposited on fiber tow 120. In some examples, the coating material may be configured to react with fiber tow 120 within central vacuum chamber 110E.

Various examples have been described. These and other examples are within the scope of the following clauses and claims.
Clause 1: A method includes continuous vacuum processing of a fiber tow, wherein the continuous vacuum processing comprises: passing a fiber tow through a plurality of vacuum chambers; and operating at least two vacuum chambers of the plurality of vacuum chambers at a different level of vacuum pressure than each other.
Clause 2: The method of clause 1, wherein the plurality of vacuum chambers are arranged in series, and wherein passing the fiber tow through the plurality of vacuum chambers comprises passing the fiber tow through a central vacuum chamber which is at the lowest pressure of the plurality of vacuum chambers.
Clause 3: The method of clause 2, wherein the central vacuum chamber comprises at least one of a chemical vapor deposition (CVD) chamber, a coating chamber, or an inspection chamber.
Clause 4: The method of clause 2, wherein the pressure inside the central vacuum chamber is less than about 500 millitorr.
Clause 5: The method of clause 2, wherein the central vacuum chamber comprises an objective chamber.
Clause 6: The method of clause 5, wherein continuous vacuum processing of the fiber tow comprises chemically reacting a portion of the fiber tow in the objective chamber.
Clause 7: The method of clause 2, further comprising coating the fiber tow with coating material in the central vacuum chamber.
Clause 8: The method of clause 1-7, wherein the plurality of vacuum chambers arranged in series include a first vacuum chamber which the fiber tow passes through first, a last vacuum chamber which the fiber tow passes through last, and wherein the first vacuum chamber and the last vacuum chamber are at a higher pressure (lower vacuum level) than the central vacuum chamber.
Clause 9: The method of any of clauses 1-9, further comprising heating the central vacuum chamber.
Clause 10: The method of any of clauses 1-9, wherein passing the fiber tow through a plurality of vacuum chambers comprises passing the fiber tow through an inlet defined by a vacuum chamber of the plurality of vacuum chambers and passing the fiber tow through an outlet defined by the vacuum chamber of the plurality of vacuum chambers.
Clause 11: The method of any of clauses 1-10, wherein at least two of the plurality of vacuum chambers share a wall.
Clause 12: The method of any of clauses 1-11, wherein at least one of the vacuum chambers is a tube surrounding the fiber tow.
Clause 13: The method of any of clauses 1-12, further comprising applying a sealing material to the fiber tow, wherein the sealing material is configured to reduce leakage into a vacuum chamber of the plurality of vacuum chambers.
Clause 14: The method of clause 12, wherein the sealing material is applied to the fiber tow before the fiber tow enters a first vacuum chamber of the plurality of vacuum chambers.
Clause 15: The method of any of clauses 1-14, wherein the plurality of vacuum chambers comprises at least five vacuum chambers.
Clause 16: A system includes a plurality of vacuum chambers; and a fiber system; wherein the fiber system is configured to continuously pass a fiber tow through the plurality of vacuum chambers, wherein at least two vacuum chambers of the plurality of vacuum chambers are configured to operate at a different level of vacuum pressure from each other.
Clause 17: The system of clause 16, wherein the plurality of vacuum chambers are arranged in series, and wherein a central vacuum chamber of the plurality of vacuum chambers is configured to operate at a lower pressure than the other vacuum chambers in the plurality of vacuum chambers.
Clause 18: The system of clause 16, wherein the central vacuum chamber comprises at least one of a chemical vapor deposition (CVD) chamber, a coating chamber, or an inspection chamber.
Clause 19: The system of clause 16, wherein the central vacuum chamber is configured to operate at a pressure of less than about 500 millitorr.
Clause 20: The system of clause 19, wherein the central vacuum chamber comprises an objective chamber.
Clause 21: The system of clause 20, wherein the objective chamber is configured to chemically react a portion of the fiber tow disposed therein.
Clause 22: The system of clause 20, wherein the objective chamber is configured to coat a portion of the fiber tow disposed therein with coating material.
Clause 23: The system of clause 16, wherein the plurality of vacuum chambers arranged in series include a first vacuum chamber which the fiber tow is configured to pass through first, a last vacuum chamber which the fiber tow is configured to pass through last, and wherein the first vacuum chamber and the last vacuum chamber are configured to operate at a higher pressure than the central vacuum chamber.
Clause 24: The system of clause 16, further comprising a heating element configured to heat the objective chamber to at least about 1400 degrees Celsius.
Clause 25: The system of any of clauses 16-24, wherein at least two of the plurality of vacuum chambers share a wall.
Clause 26: The system of any of clauses 16-25, wherein at least one of the vacuum chambers is a tube surrounding the fiber tow.
Clause 27: The system of any of clauses 16-26, further comprising a sealing system configured to apply a sealing material to the fiber tow, wherein the sealing material is configured to reduce leakage into a vacuum chamber of the plurality of vacuum chambers.
Clause 28: The system of clause 27, wherein the sealing material system is configured to apply the sealing material to the fiber tow before the fiber tow enters a first vacuum chamber of the plurality of vacuum chambers.
Clause 29: The system of any of clauses 16-28, wherein the plurality of vacuum chambers comprises at least five vacuum chambers.
Clause 30: The system of any of clauses 16-29, wherein each respective vacuum chamber of the plurality of vacuum chambers is outfitted with a corresponding vacuum pump configured to reduce the atmospheric pressure in the vacuum chamber.
Clause 31: The system of any of clauses 16-30, wherein at least one vacuum chamber of the plurality of vacuum chambers defines an inert gas inlet configured to receive inert gas from an inert gas supply.

## Claims

1. A system comprising:
a plurality of vacuum chambers; and
a fiber system;
wherein the fiber system is configured to continuously pass a fiber tow through the plurality of vacuum chambers,
wherein at least two vacuum chambers of the plurality of vacuum chambers are configured to operate at a different level of vacuum pressure from each other.

2. The system of claim 1, wherein the plurality of vacuum chambers are arranged in series, and wherein a central vacuum chamber of the plurality of vacuum chambers is configured to operate at a lower pressure than the other vacuum chambers in the plurality of vacuum chambers.

3. The system of claim 1 or claim 2, wherein the central vacuum chamber comprises at least one of a chemical vapor deposition (CVD) chamber, a coating chamber, or an inspection chamber.

4. The system of claim 2 or claim 3, wherein the central vacuum chamber is configured to operate at a pressure of less than about 500 millitorr.

5. The system of any of claims 2-4, wherein the central vacuum chamber comprises an objective chamber.

6. The system of claim 5, wherein the objective chamber is configured to chemically react a portion of the fiber tow disposed therein.

7. The system of claim 5 or claim 6, wherein the objective chamber is configured to coat a portion of the fiber tow disposed therein with coating material.

8. The system of any of claims 2-7, wherein the plurality of vacuum chambers arranged in series include a first vacuum chamber which the fiber tow is configured to pass through first, a last vacuum chamber which the fiber tow is configured to pass through last, and
wherein the first vacuum chamber and the last vacuum chamber are configured to operate at a higher pressure than the central vacuum chamber.

9. The system of any of claims 1-8, further comprising a heating element configured to heat the objective chamber to at least about 1400 degrees Celsius.

10. The system of any of claims 1-9, wherein at least two of the plurality of vacuum chambers share a wall.

11. The system of any of claims 1-10, wherein at least one of the vacuum chambers is a tube surrounding the fiber tow.

12. The system of any of claims 1-11, further comprising a sealing system configured to apply a sealing material to the fiber tow, wherein the sealing material is configured to reduce leakage into a vacuum chamber of the plurality of vacuum chambers.

13. The system of claim 12, wherein the sealing material system is configured to apply the sealing material to the fiber tow before the fiber tow enters a first vacuum chamber of the plurality of vacuum chambers.

14. The system of any of claims 1-13, wherein the plurality of vacuum chambers comprises at least five vacuum chambers.

15. A method comprising:
continuous vacuum processing of a fiber tow, wherein the continuous vacuum processing comprises:
passing a fiber tow through a plurality of vacuum chambers; and
operating at least two vacuum chambers of the plurality of vacuum chambers at a different level of vacuum pressure than each other.
